Europäisches Patentamt

European Patent Office

Office européen des brevets

(19)

(11) Publication number: 0 193 820

A2

(12) **EUROPEAN PATENT APPLICATION**

(21) Application number: 86102335.6

(22) Date of filing: 22.02.86

(51) Int. Cl.4: **H01L 31/18** , H01L 31/02 , H01L 21/00

(30) Priority: 27.02.85 JP 39910/85
23.01.86 JP 12869/86

(43) Date of publication of application:
10.09.86 Bulletin 86/37

(84) Designated Contracting States:
BE CH DE FR GB IT LI NL SE

(71) Applicant: KANEGAFUCHI KAGAKU KOGYO
KABUSHIKI KAISHA
2-4 Nakanoshima 3-chome
Kita-ku Osaka-shi Osaka-fu(JP)

(72) Inventor: Hiroe, Akihiko
31-17, Shioya-cho 6-chome Tarumi-ku
Kobe-shi Hyogo-ken(JP)
Inventor: Takamatsu, Osamu
31-17, Shioya-cho 6-chome Tarumi-ku
Kobe-shi Hyogo-ken(JP)
Inventor: Nakayama, Takehisa
9-30-1020, Maikodai 2-chome Tarumi-ku
Kobe-shi Hyogo-ken(JP)
Inventor: Tawada, Yoshihisa
14-39, Oikemiyamadai Kita-ku
Kobe-shi Hyogo-ken(JP)
Inventor: Tsuge, Kazunori
9-30-1220, Maikodai 2-chome Tarumi-ku
Kobe-shi Hyogo-ken(JP)

(74) Representative: Gille, Christian, Dipl.-Ing. et al
Türk & Gille Bruckner Strasse 20
D-4000 Düsseldorf 13(DE)

(54) Method for forming a thin film pattern.

(57) A method for forming a thin film pattern comprising the steps in sequence of forming a lift-off layer directly on a substrate wherein a pattern of the lift-off layer is reverse to a desired thin film pattern, forming a thin film on the substrate, removing an undesirable portion of the thin film together with the lift-off layer; and a method for producing a semiconductor device comprising the steps in sequence of forming a first electrode on an insulated substrate, removing a part of the first electrode, forming a semiconductor including amorphous material on the first electrode, forming a lift-off layer on the semiconductor including amorphous material at such a place whereon a second electrode is not desired to be formed, and forming a second electrode on the semiconductor.

According to the present invention, a thin film pattern can be formed at low production cost, with high productivity and accuracy, and with less danger during the process.

*FIG. 3*

## METHOD FOR FORMING A THIN FILM PATTERN

The present invention relates to a method for forming a thin film pattern wherein a lift-off method is employed and a method for producing a semiconductor device.

Hitherto, there have been employed the following methods as a method for forming thin films such as a metal electrode of a sollar cell to have desired patterns.

(1) A mask method comprising forming a pattern by mechanically preventing a thin film from adhering to undesirable portions of a substrate using a mask.

(2) A etching method, employed in case that a patterning with higher accuracy is required as in the case of, for example, an element which requires a minute patterning or high degree of integration, comprising the steps in sequence of forming a thin film on the whole surface of a substrate; coating a resist having a desirable pattern on the thin film by screen printing, or exposing and developping a resist coated on the whole surface of the thin film to obtain a desirable pattern; and removing the thin film by etching whereon a resist is not coated to obtain patterned thin film.

(3) A lift-off method comprising the steps in sequence of coating a resist on the whole surface of a substrate before the formation of a thin film; exposing and developping the resist to obtain a reserve pattern which is used as a lift-off layer for removing undesirable portions of the thin film; forming the thin film on the whole surface of the substrate; and removing the undesirable portions of the thin film formed on the lift-off layer together with the lift-off layer.

The above-mentioned conventional methods, however, have several drawbacks. The mask method, for example, has a problem that evaporated atoms or sputtered atoms intude into a gap between a mask and substate due to the poor working accuracy of the mask and poor adhesion between the mask and substrate during the formation of a thin film employing a vapor deposition method, sputter method, and the like. The mask method further has a problem that there is generated a shadow of the mask on the substrate because of the thickness of an edge of the mask. In case of carrying out in sputtoring of metal thin film, in particular, there is terribly taken place the above intruding of atoms since the sputtered atoms have high level of energy, and accordingly the obtained thin film cannot be used.

On the other hand, with respect to an etching method using a resist, there are problems in production cost, productivity and damage to a substate since there are required processes such as an exposure and development process of a resist, an etching process of a thin film and a removal process of the resist. The usable etching liquid is limited depending on the kinds of thin films. The etching liquid is narrowly limited in case of employing, for example, a-Si, a-SiC or some kinds of metal silicide. Further, the usable etching liquid is generally dangerous and the etching speed is low, which are the essential problems of an etching liquid.

In the conventional lift-off method, further, the same problems as in the above-mentioned etching method take place when developping or removing a resist in the patterning step of a lift-off layer.

It is an object of the present invention to provide a method which remove the above-mentioned drawbacks in the conventional patterning method of a thin film.

In accordance with the present invention, there is provided a method for forming a thin film pattern comprising the steps in sequenece of forming on a substrate directly beforehand a lift-off layer having a pattern reverse to a prescribed thin film pattern, coating a thin film on the whole surface of the substrate, and removing an undesirable portion of the thin film together with the lift-off layer to obtain the prescribed thin film pattern.

In accordance with the present invention, there is further provided a method for producing a semiconductor device comprising the steps in sequence of forming a first electrode on an insulated substrate, removing a part of the first electrode, forming a semiconductor including amorphous material on the first electrode, forming a lift-off layer on the semiconductor including amorphous material at such a place whereon a second electrode is not desired to be formed, and forming a second electrode on the semiconductor.

Fig. 1 is a view explaining a state wherein a lift-off layer providing a reserve pattern of a thin film is formed on a substrate and thereafter a thin film is coated on the whole surface of the substrate;

Fig. 2 a view explaining a part of a pattern employed in Examples 1 and 2 in the present invention;

Fig. 3 is a view explaining a monolithically integrated sollar cell produced in Example 3 in the present invention;

Figs. 4 to 7 are views explaining each step of an embodiment when producing a semiconductor device in accordance with the present invention wherein

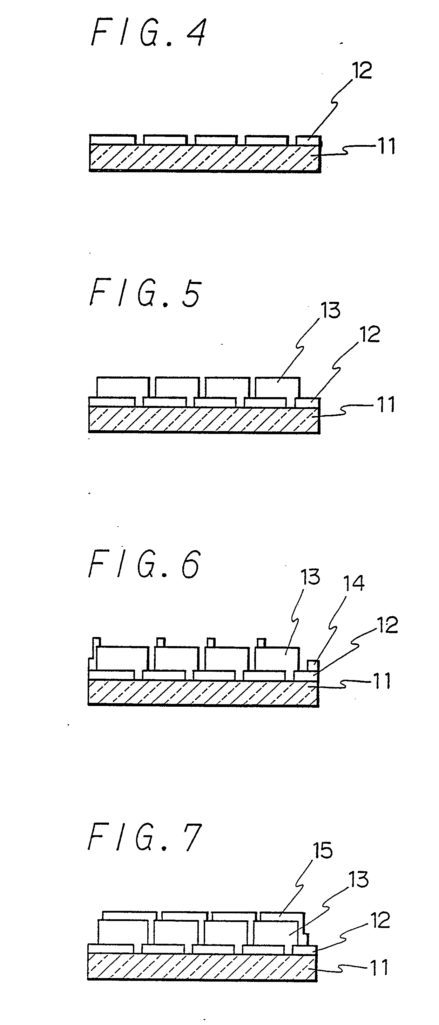

Fig. 4 is a view explaining a state wherein a substrate comprising a glass plate and $SnO_2$-electrode provided thereon is etched;

Fig. 5 is a view explaining a state wherein a semiconductor is formed on the substrate of Fig. 4 and thereafter only a part of the semiconductor is scribed;

Fig. 6 is a view explaining a state wherein slurry is coated on the semiconductor of Fig. 5 by screen printing and thereafter the slurry is dried; and

Fig. 7 is a view explaining a sollar cell produced in accordance with a method of the present invention.

Examples of lift-off layers used in the present invention are, for instance, a water soluble resin or a solvent soluble resin which dissolves by the contact with a water or organic solvent respectively; a resin obtained by dispersing inorganic particles having an average particle size of about 0.05 to 50 $\mu$m into the above-mentioned water soluble resin or solvent soluble resin; a silicone grease prepared by adding materials for increasing consistency such as carbon black, metal soap, fluorine-containing resin and metal oxide to silicone oil, the consistency of the silicone grease being 150 to 400 (measured at 25°C after kneading 60 times, hereinafter the same), preferably 290 to 330; and an oil ink.

The lift-off layer is formed by, for instance, screen printing a silicone grease, and printing or patterning an oil ink by using a plotter or ink jet method. The thickness of the layer is about 1 to 100 $\mu$m, preferably about 10 to 25 $\mu$m.

The lift-off layer of the present invention preferably has properties such as a uniform wettablity which is strong enough to lessen the adhesion of a thin film formed on the lift-off layer to a substrate. The lift-off layer is formed on the substrate directly without employing etching method in order to obtain a desirable reverse pattern.

Examples of substrates used in the present invention are, for instance, substrates comprising glass, ceramics, organic polymer material such as epoxy resin and fluorine-containing resin, insulated metal plate. The substrates in the present invention are not limited to those described above and any substrate is employable as long as it can be generally used in the production of semiconductor device. The thickness of the substrates is about 0.05 to 10 mm.

The substrates used in the present invention might be a glass substrate whereon an electrode is provided, the above glass substrate or metal substrate whereon a semiconductor layer such as an amorphous semiconductor is further provided respectively. That is, any substrate is employable as long as a lift-off layer can be formed thereon.

The lift-off layer in the present invention exists as a reverse pattern between a substrate and a thin film formed after providing the lift-off layer on the substrate. The lift-off layer is removed together with the thin film formed on the lift-off layer in order to form a thin film pattern under which the lift-off layer is not provided. The removal of the lift-off layer can be carried out by using a solvent suitable for dissolving a material of the lift-off layer.

The thin film in the present invention is not limited particularly and any thin film is employable as long as it is formed as a pattern by the lift-off method. The thickness of the thin film, which is not limited particularly, is generally about 10 to 10000 Å, preferably about 1000 to 5000 Å.

Referring now to the accompanied drawings, a method of the present invention is explained.

A silicone grease or ink having suitably adjusted consistency is printed by screen printing, and the like on a substrate 1, whereon a thin film 3 is designed to be coated, in order to form a lift-off layer 2 as a pattern. The obtained pattern is reverse with respect to a desirable thin film pattern. The silicone grease or ink used in this step is preferably not in danger of causing the dullness of a pattern, or the invasion of impurity during the formation of the thin film. The silicone grease or ink is also preferably removable with ease on removing the lift-off layer. In case of thin film deposition in vacuo, a silicone grease prepared by adding material for increasing consistency to silicone oil, a resist having adjusted consistency employed generally in etching, and the like are employable. When the substrate has a large surface area and the accuracy is required with a pattern, it is preferable to employ ink jet method instead of screen printing. A water ink or oil ink can be used in order to form the lift-off layer more briefly, wherein a pen having superior accuracy such as a drawing pen, for instance a rotring pen ®, is employed.

The thin film 3 is coated on the whole surface of the substrate 1 after the formation of the lift-off layer. The pattern is formed completely by simultaneously removing the lift-off layer 2 and the thin-film 3 thereon.

As a method of forming a thin film, there can be employed a resistive heat evaporation method, electron-beam vapor deposition method, DC (Direct Current) or RF - (Radio Frequency) sputtering method, atomospheric or vaccum CVD (Chemical Vapor Deposition) method, photo CVD method, plasma CVD method, and the like. Any method for forming a thin film can be employed as long as it is not harmful to a lift-off layer.

The thin film patterned in accordance with the above-mentioned method can be widely utilized as a transparent conductive thin film or metal thin film used as an electrode of various devices; as a thin film of metal silicide used for protecting the above transparent conductive thin film or metal thin film; as an amorphous or crystalline semiconductor thin film appliable for sollar cell, photo sensor, photo receptor for electrophotography, thin film diode, transistor, and the like; and as an amorphous or crystalline insulating thin film appliable for the insulating film or IC of hybrid IC substrate or other various insulating protect film.

As a solvent used for removing the lift-off layer, there can be utilized, in case of using silicone grease as a lift-off layer, trichlene, acetone, n-hexane, ethanol, petroleum ether, and the like. Among them, trichlene or n-hexane is particularly suitable as a solvent in case of using silicone grease as a lift-off layer. On the other hand, in case of forming a lift-off layer using an ink by ink jet method, acetone or ethanol is preferable.

An ultrasonic cleaning is helpful in improving the removal speed of a lift-off layer. The use of ultrasonic cleaning is, however, to be limited to such a degree that is not harmful to a substrate or thin film which is designed to form a pattern.

An example of a method effective in removing a lift-off layer as well as the above-mentioned ultrasonic cleaning is a method wherein a solvent is flown on the surface of the thin film, which is particularly useful in case that a silicone grease is used as a material for the lift-off layer.

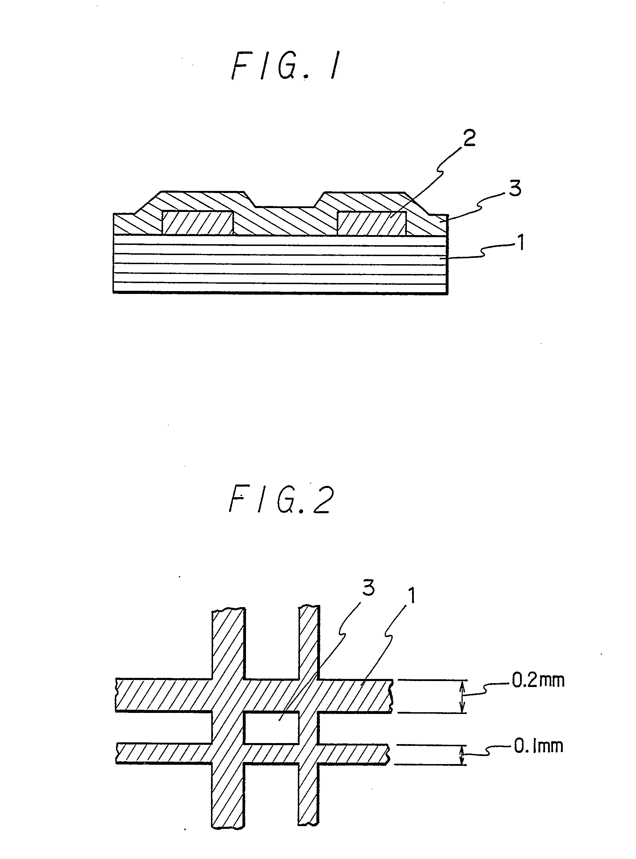

By employing a method described above, there can be obtained a thin film pattern having high accuracy at low production cost, with good productivity without using specific etching liquid. The high accuracy is such that, for example in the case of a pattern shown in Fig. 2, the width of a line is 0.15 to 0.2 mm and the position accuracy is about 0.1 mm.

According to the present invention, the "substrate" whereon a lift-off layer is coated might be, as described above, a semiconductor layer under which an electrode - (thin film) is provided. In that case, the first electrode is formed on the substrate firstly and removed partially. A semiconductor including amorphous material is then formed on the first electrode. The lift-off layer is provided on the semiconductor at such a place whereon the second electrode is not desired to be formed. At last the second electrode is obtained by forming the second electrode on the semiconductor and then removing the lift-off layer together with a part of the second electrode provided on the lift-off layer.

There can be used the same kinds of substrate as described above with this case.

On the substrate there is formed as a first electrode a metal electrode such as SUS, iron, Al, Ni, Cu, brass, Zn, Ag and an alloy thereof; a transparent electrode such as ITO, $In_2O_3$, $SnO_3$, $ITO/SnO_2$, $Cd_xSnO_y$ (wherein x and y satisfy the relationship of $0.5 \leq x \leq 2$ and $2 \leq y \leq 4$), $Ir_zO_{l-z}$ (wherein z satisfies the relationship of $0.33 \leq z \leq 0.5$) and $Zn_mO_{l-m}$ (wherein m satisfies the relationship of $0 \leq m \leq 0.5$); a silicide electrode such as Cr-Si and Mo-Si. The thickness of the first electrode is about 100 to 10000 Å.

A part of the first electrode formed on a substrate is removed by employing, for instance, etching method in order to obtain the desired pattern. Next, a semiconductor including amorphous material is formed on the first plate. Then, a material for the lift-off layer is coated, preferably in the state of solution, on the semiconductor including amorphous material at such a place whereon the second electrode is not desired to be formed.

Concrete examples of the above-mentioned semiconductor including amorphous material are, for instance, a semiconductor including at least one of Si, Ge and C, a semiconductor including nitrogen or oxgen atom besides at least one of Si, Ge and C. The dangling bond of the formed semiconductor might be terminated by hydrogen or fluorine atoms. The thickness of the semiconductor is about 50 Å to 50 μm. The semiconductor including amorphous material might includes microcrystal. The structure of the semiconductor including amorphous material is, for example, pn, pin, MIS (Metal Insulator Semiconductor) and SB (Schottky Barrier).

In coating a material for forming a lift-off layer on the semiconductor including amorphous material, there can be employed a method wherein a liquid material is coated by printing to form a desired pattern, or a method wherein a liquid material is sprayed through minute nozzles. The coating method is not limited to these two methods and any method is employable as long as a pattern having high accuracy can be obtained.

After forming a lift-off layer and drying it, if necessary, there is formed by conventional method the second electrode of about 10 to 10000 Å in thinkness comprising the same material as the first electrode. The second electrode is then dipped into a solvent which dissolves the lift-off layer in order to remove the lift-off layer together with a part of the second electrode on the lift-off layer rubbing the surface with soft cloth or sponge, if necessary. Then a pattern of the second electrode can be obtained accurately and easily.

In case of using silicon compound as a lift-off layer having high boiling point, a metal is hard to adhere to the lift-off layer whereby the second electrode can be obtained by merely washing the silicon compound.

The semiconductor devices produced in accordance with the above-mentioned method do not contain a material, such as an etching liquid and resist, remained in the devices which remarkably lessens the reliability of the devices. The minute pattern having high reliability and accuracy almost equal to that obtained by etching method can be obtained easily, and is suitably used as a sollar cell, photo sensor, TFT (Thin Film Transistor), CCD (Charge Coupled Device), and the like.

In the above explanation, a material for forming a ligt-off layer is coated on a semiconductor including amorphous material formed on the first electrode. The semiconductor device, however, can be produced by removing a part of the first electrode, forming a semiconductor including amorphous material on the first electrode by using laser or mechanical scratch, coating a material for forming a lift-off layer on the semiconductor at such a place whereon the second eletorde is not desired to be formed. Further, the semiconductor device can be produced by simultaneously removing a part of the first electrode and a part of a semiconductor including amorphous material formed on the first electrode, coating a material for forming a lift-off layer on the semiconductor at such a place whereon the second electrode is not desired to be formed.

It goes without saying that a method of the present invention can be employed not only in forming the above-mentioned functional thin film but also in patterning an usual thin film such as a glossy metal thin film for ornament.

Referring now to Examples 1 to 5, a method of the present invention is explained.

Example 1

Silicone grease (SH7071 made by Toray Silicone K. K.) was patterned by screen printing on a square green plate glass of 127 mm x 127 mm to form a lift-off layer of about 30 μm in thickness. Al was deposited on the whole surface of the obtained lift-off layer by resistive heat evaporation method to form a thin film of 1000 Å in thickness. The thin film of A1 formed on the lift-off layer was removed together with the lift-off layer by ultrasonic cleaning method using trichlene as a solvent. The pattern employed in forming the lift-off layer by screen printing comprised fine lines of 0.1 mm and 0.2 mm in width which cross each other. Fig. 2 explains a part of the pattern employed in Example 1.

With respect to a pattern of the obtained thin film of Al, the minimum width of a line obtained by using a pattern of 0.1 mm was 0.15 mm.

In case of forming a thin film pattern of Al under the same experimental conditions except that sputter vapor deposition method was employed instead of screen printing method, there could be obtained a pattern wherein the line width was about 0.13 mm.

The accuracy of the patterning in both experimental results was such that could not be obtained by the present technique using a mechanical mask. There could be obtained a thin film pattern with high accuracy wherein much less process was required than the etching method or conventional lift-off method.

Example 2

A patterning step was carried out using the same pattern and the same method in Example 1 except that a parallel-flat type plasma CVD equipment was employed in order to form a thin film of a-Si.

The thin film of a-Si was formed under the following conditions.

Temperature of a substrate : 200°C

Pressure in reaction chamber: 0.5 Torr

Flow of silane : 10 SCCM

Plasma power : about 30 mW/cm$^2$

Time for forming a thin film: 30 minutes

Thickness of a thin film : about 1 μm

The minimum width of a line obtained by using a pattern of 0.1 mm was 0.15 mm.

Example 3

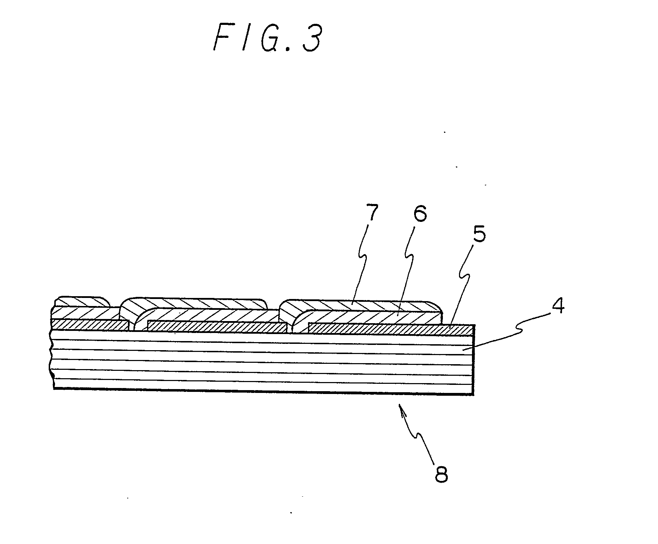

A patterned transparent electrode 5 was formed beforehand on a square heat resistance glass substrate 4 of 127 mm x 127 mm. On the whole surface of the obtained electrode, there was formed pin type amorphous silicon sollar cell 6 comprising boron-doped a-Si as a p-layer, nondoped a-Si as a i-layer and phosphine-doped a-Si as a n-layer. The sollar cell as patterned by laser scribing. Thereafter, a lift-off layer of which line width was 0.2 mm was printed on the sollar cell in accordance with the same method of Example 1. Al was deposited thereon and the Al layer 7 on the lift-off layer was removed together with the lift-off layer in order to obtain a sixteen-decker integrated sollar cell 8 shown in Fig. 3, which was evaluated as a sollar cell.

The area efficiency (ratio of cell area to the whole substrate area) of the obtained monolithically integrated sollar cell was about 90 % which was greatly improved in comparison with the area efficiency of 80 to 83 % obtainable by conventional mask method. The net efficiency of the sollar cell was 8.5 %.

Example 4

A substrate comprising a glass 1 and $SnO_2$-electrode 2 provided thereon was etched to form such a band-like pattern as shown in Fig. 4. There was formed on the substrate by employing glow electric discharge method a semiconductor 13 comprising a p-type a-SiC:H of 120 Å in thickness, intrinsic a-Si:H of 6000 Å and n-type $\mu$C-Si:H of 500 Å. Only a portion of semiconductor was scribed in parallel by using YAG laser as shown in Fig. 5, wherein the scribed location was sifted or moved from the pattern of $SnO_2$-electrode, that is, the scribed location did not overlap the pattern of $SnO_2$-electrode. A slurry prepared by dispersing 60 parts (parts by weight, hereinafter the same) of talc having an average particle size of 0.5 $\mu$m, 25 parts of calcium carbonate having an average particle size of 1.5 $\mu$m and 5 parts of polyvinyl alcohol of low degree of polymerization into water was coated on the semiconductor by screen printing to obtain a coating of 10 $\mu$m in thickness. The printed slurry 4 was formed as shown in Fig. 6 and was dried at 70°C. Next, Al-electrode 15 was deposited on the whole surface of the substrate. The substrate was cleaned by ultrasonic cleaning method for about 3 minutes in warm water of 50°C in order to obtain a sollar cell shown in Fig. 7.

The properties of the obtained sollar cell was same as those of sollar cell obtained by chemically etching Al-electrode. In case of heating the sollar cell obtained by etching method for 10 hours at 100°C, however, the properties thereof as a sollar cell was reduced to one-tenths of initial properties. On the contrary, the properties of the sollar cell obtained in accordance with the present invention was increased by 15 %.

Example 5

Silicone oil instead of the slurry used in Example 1 was coated on a substrate by using ink jet printer to form a pattern shown in Fig. 6. Thereafter Al was deposited on the substrate. A sollar cell having good properties could be obtained without any further step since Al did not adhere to such portions that were coated with silicone oil.

As is described above, there can be formed a thin film pattern at low production cost, with high productivity and accuracy, and with less danger during the process by employing a method for forming a thin film pattern of the present invention.

**Claims**

1. A method for forming a thin film pattern comprising the steps in sequence of forming a lift-off layer directly on a substrate wherein a pattern of the lift-off layer is reverse to a desired thin film pattern, forming a thin film on the substrate, and removing an undesirable portion of the thin film together with the lift-off layer.

2. The method of Claim 1, wherein the lift-off layer is directly formed on the substrate by screen printing.

3. The method of Claim 2, wherein the lift-off layer is directly formed on the substrate by screen printing using a silicone grease.

4. The method of Claim 1, wherein the lift-off layer is directly formed on the substrate by ink jet method using a ink.

5. The method of Claim 1, wherein the thin film is a transparent conductive thin film.

6. The method of Claim 1, wherein the thin film is a metal thin film.

7. The method of Claim 1, wherein the thin film is a silicide thin film.

8. The method of Claim 1, wherein the thin film is an amorphous semiconductor thin film.

9 The method of Claim 1, wherein the thin film is a crystalline semiconductor thin film.

10. The method of Claim 1, wherein the thin film is an amorphous insulating thin film.

11. The method of Claim 1, wherein the thin film is a crystalline insulating thin film.

12. The method of Claim 1, wherein the substrate whereon the lift-off layer is directly formed is a substrate having an amorphous semiconductor layer thereon.

13. The method of Claim 1, wherein the lift-off layer comprises liquid organic compound having small vapor pressure, or water-soluble or organic solvent-soluble solid material.

14. A method for producing a semiconductor device comprising the steps in sequence of forming a first electrode on an insulated substrate, removing a part of the first electrode, forming a semiconductor including amorphous material on the first electrode, forming a lift-off layer on the semiconductor including amorphous material at such a place whereon a second electrode is not desired to be formed, and forming a second electrode on the semiconductor including amorphous material.

15. The method of Claim 14, wherein a part of the semiconductor including amorphous material formed on the first electrode is removed after removing a part of the first electrode, and then a lift-off layer is formed on the semiconductor including amorphous material at such a place whereon a second electrode is not desired to be formed.

16. The method of Claim 14, wherein a part of the first electrode and a part of the semiconductor including amorphous material formed on the first electrode are removed simultaneously, and then a lift-off layer is formed on the semiconductor including amorphous material at such a place whereon a second electrode is not desired to be formed.

17. The method of Claim 14, wherein the lift-off layer comprises liquid organic compound having small vapor pressure, or water-soluble or organic solvent-soluble solid material.

# FIG. 1

# FIG. 2

0.2mm

0.1mm

# FIG. 3

## F I G . 4

## F I G . 5

## F I G . 6

## F I G . 7